Europäisches Patentamt

European Patent Office

Office européen des brevets

(19)

(11) Publication number: 0 043 958
A2

# (12) EUROPEAN PATENT APPLICATION

(21) Application number: 81104940.2

(22) Date of filing: 25.06.81

(51) Int. Cl.³: G 01 R 21/00
H 05 B 6/00

(30) Priority: 10.07.80 US 167304

(43) Date of publication of application:
20.01.82 Bulletin 82/3

(84) Designated Contracting States:
AT BE CH DE FR GB IT LI LU NL SE

(71) Applicant: Litton Systems, Inc.
360 North Crescent Drive
Beverly Hills California 90210(US)

(72) Inventor: Buck, Ronald G.
165 Red Fox Rd. S.E.
Cedar Rapids Iowa 52403(US)

(72) Inventor: Carpenter, Lowell L.
6065 Rhode Island Ave. N.
New Hope MN 55428(US)

(72) Inventor: Curry, Stephen M.
5627 Monticello Ave.
Dallas TX 75206(US)

(72) Inventor: Irwin, Thomas D.
1408 N. Floyd.
Richardson TX 75080(US)

(72) Inventor: Larson, Gerald L.
3506 W. Sunrise Dr.
Minnetonka MN 55343(US)

(72) Inventor: McNutt, Reginald L.
805 Harbor Lane
Minneapolis MN 55441(US)

(74) Representative: Patentanwälte Grünecker,
Dr.Kinkeldey Dr.Stockmair, Dr.Schumann,Jakob,
Dr.Bezold Meister, Hilgers, Dr.Meyer-Plath
Maximilianstrasse 43
D-8000 München 22(DE)

(54) Power sensing in a microwave oven.

(57) Method and apparatus for power sensing in a microwave oven. A signal proportional to the voltage across the primary of the high voltage transformer and a signal proportional to the current through the primary are multiplied together by a four-quadrant analog multiplier. The output of the multiplier is integrated for a predetermined number of line cycles. The integrated value is then converted to a digital value representative of power.

Fig. 1

GRÜNECKER, KINKELDEY, STOCKMAIR & PARTNER

**0043958**

PATENTANWÄLTE
EUROPEAN PATENT ATTORNEYS

A GRÜNECKER, DIPL.-ING
DR H. KINKELDEY, DIPL.-ING
DR W. STOCKMAIR, DIPL.-ING, AE E (CALTECH)
DR K. SCHUMANN, DIPL.-PHYS
P. H JAKOB, DIPL.-ING
DR G. BEZOLD, DIPL.-CHEM
W MEISTER, DIPL.-ING
H HILGERS, DIPL.-ING
DR H. MEYER-PLATH, DIPL.-ING

8000 MÜNCHEN 22
MAXIMILIANSTRASSE 43

# POWER SENSING IN A MICROWAVE OVEN

## Background of the Invention

### 1. Field of the Invention.

This invention pertains generally to the field of microwave ovens and more particularily to sensing power input to the microwave oven's magnetron.

### 2. Brief Description of the Prior Art.

With advances in the art of microwave ovens, the need has arisen for a knowledge of the power consumed by the magnetron. With the knowledge of power being consumed by the magnetron, a method of microwave cooking may be used to compute cooking time as a function of power consumption. See the copending application to Buck, Serial Number 73,077, filed September 6, 1979 and assigned to the assignee of the present invention.

Disclosed in said application is a method of sensing power on the high voltage side of the magnetron's high voltage transformer. While such a method may be implemented, it suffers drawbacks relating to the cost of components that must be used with the very high voltages present on the high voltage side of the transformer.

Sensing power on the low voltage side of the ~~side of the~~ *
high voltage transformer, while reducing the cost of
components disclosed in the Buck application, cannot be
accomplished with accuracy using the Buck circuit due to
the fact that power on the low voltage side of the transformer is only an indirect indication of power on the high
voltage side. Moreover, the current wave is highly complex.
It includes significant power in higher harmonics as well
phase shifts and other distortion. Multiplying average
peak voltage time average current can be expected to yield
significant errors.

Summary of the Invention

Accordingly, it is an object of the present invention to
provide power sensing on the low voltage side of the high
voltage transformer of a magnetron's power supply circuit.
Power sensing is achieved by providing means to generate a
signal representative of current through the low voltage
primary windings of the high voltage transformer and means
to generate a second signal representative of the voltage
across the primary winding. This latter signal is branched
and inverted to form a complement signal. The two signals
representative of the voltage across the primary winding are
each fed through a switch into a summing junction, which is
then fed into a dual slope integrating analog to digital
converter. The signal representative of current is amplified
and fed to the inverting input of a comparitor. The other
input to the comparitor is coupled through a capacitor to a
triangle wave generator. The output of the comparitor is a
width modulated pulse train representative of instantaneous
current amplitude. This output directly controls the
opening and closing of the switch in the voltage signal
path. The output is also inverted. The inverted output
controls the opening and closing of the switch in the
complement voltage signal path. The multiplier output at
the summing junction is therefore pulse width modulated

* amended

by the current signal and amplitude modulated by the voltage signals; and the total area under the voltage width-times-height curve at the input to the analog digital converter is proportional to power.

The frequency of the triangle wave input to the comparitor is chosen such that it encompasses the fifth harmonic of the current signal.

The ingegrating analog to digital converter is controlled by a microprocessor such that it causes the analog to digital converter to integrate the multiplied signal for a time sufficient to accommodate power variations into the magnetron caused by the magnetron having various output impedances placed on it. The output impedances will vary primarily due to rotation of the stirrer or stirrers mounted at the outlet of the magnetron's waveguide. Thereafter the total integrated power over this time is converted to a digital value by means of reverse integrating the integrater's capacitor toward an oppositely polarized reference voltage and timing how long it takes the capacitor to reach zero volts.

The output of the multiplication and integration circuits are proportional to the actual power; and means are provided in the circuit for factory and field calibration of the circuit.

Brief Description of the Drawings

These and other advantages and features of the present invention will become apparent in the following detailed description of the preferred embodiment when taken in view of the accompanying drawings in which like references pertain to like elements throughout the figures.

Figure 1 is functional block diagram of the overall power sensing circuit.

Figure 2 is a functional block diagram of multiplier circuit used in the preferred embodiment.

## Description of the Preferred Embodiment

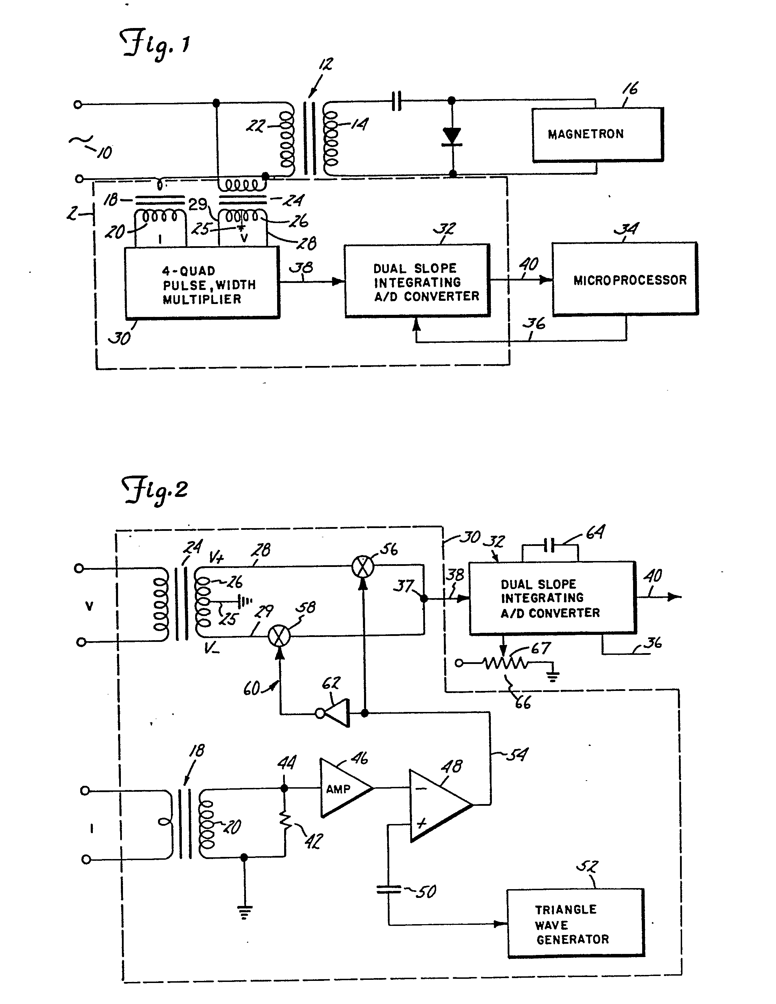

Referring to Figure 1, a functional schematic of the preferred embodiment is shown. Line voltage 10 is fed into transformer 12 which provides on its secondary 14 the high voltages necessary to operate the magnetron 16. The other circuit elements shown in the high voltage side of transformer 12 are well known in the art and need not be discussed here. On the low voltage side of the transformer 12 a current transformer 18 is used to develop a voltage in its secondary 20 proportional to the current through the primary 22 of the high voltage transformer 12. Voltage transformer 24 is used to develop a voltage signal on its secondary 26 proportional to the voltage across the high voltage transformer's primary 22. The secondary of this voltage transformer 26 is center tapped to ground. As a result, one leg of the secondary 28 can be viewed as the voltage signal and the other leg 29 can be viewed its complement.

These three signals, representative of current, voltage and complement of voltage, are provided as inputs to a four-quadrant, pulse-width modulated multiplier 30. The multiplier multiplies these two signals together to form the product, current times voltage, which is known to be equal to power. The multiplier 30 is of a type which recognizes both positive and negative current and positive and negative voltage, which may not be in phase with each other. The resultant output of the multiplier circuit 30 thus may have both positive and negative power. A positive power denotes power flowing into the magnetron 16. A negative

power denotes power flowing back from the magnetron high voltage circuit through transformer 12.

The output 38 of the multiplier is fed into a dual-slope, integrating, analog to digital coverter 32. This A/D converter 32 is controlled by microprocessor 34 via control line 36. The microprocessor causes the integrating portion of the A/D converter to integrate the output of the multiplier 38 for a time sufficient to monitor the various possibilities of power consumption of magnetron 16. These various possibilities of power consumption are caused by varying impedances on the magnetron output primarily caused by rotation of a stirrer or stirrers (not shown) on the magnetron's waveguide outlet (also not shown), as is well known in the art. In the preferred embodiment, most of the possible variations in impedances caused by rotation of symmetrical stirrer are comprised within the time it takes for the stirrer to rotate one of its fins past a fixed point, which may be on the order of 5 to 10 line cycles.

The microprocessor also repeats the measurement of power periodically in the preferred embodiment at spaced sampling intervals and averages the measurements to further accommodate variations in the power consumption of the magnetron 16. Care should be taken that this sampling interval is not in sync with the rotation of the stirrer so that one abnormally high or low reading is not periodically measured. Preferably the interval should be out of sync with stirrer rotation and have a number of samples with any given single rotation of a stirrer.

At the end of this integrating period, the microprocessor 34 commands the A/D converter 32 to stop integrating and begin integrating toward a reference voltage oppositely polarized from the charge it has on its integrating capacitor 64. The time it takes for this integrating capacitor to integrate to zero volts is thus representative of the total charge on the capacitor, which in turn is representative of the total power input to magnetron 16 during the integrating period. The A/D converter 32 signals the microprocessor via control line 40 the moment the integrating capacitor crosses zero volts. The microprocessor 34 converts the time to integrate to zero into a digital representation of power via conventional techniques.

Figure 2 is a functional schematic of the four-quadrant, pulse-width multiplier used in the preferred embodiment. Alternative embodiments may employ other known multiplication techniques, so long as they accurately accommodate arbitrary phase shifts and harmonic distortion, preferably to the fifth harmonic. Such an alternate multiplier is a four-quadrant transconductance multiplier.

Referring to Figure 2, the secondary of current transformer 18 is coupled across resistor 42 to develop a signal at 44 representative of or proportional to current through the high voltage transformer primary 22. This current signal typically has a very low voltage. Thus, it is provided as an input to amplifier 46 which scales it up to a voltage usable by following circuitry. The output of amplifier 46 is provided as an input to the inverting input of comparitor 48. The other input to comparitor 48 is coupled through capacitor 50 to triangle wave generator 52. The triangle wave from generator 52 is a saw tooth wave cycling periodically between a plus and a minus voltage slightly larger in magnitude than the peak magnitude of the current signal.

Due to input offsets of the circuitry used to generate the triangle wave, the output of the triangle wave generator 52 may be asymmetrical relative to zero volts. Capacitor 50 does not transmit the DC offset. As a result, the input to the non inverting input of comparitor 48 is symmetrical about zero volts.

The output 54 of comparitor 48 is a pulse train of ones and zeros whose pulse-width is proportional to the current signal, as is known in the art. Reference made to United States Letters Patent 3,947,763 to Milkovic and Figure 3 thereof.

The voltage across the primary 22 of the high voltage transformer 12 is coupled through voltage transformer 24 to produce on the secondary 26, which is center tapped to ground, a signal representative of or proportional to the voltage. Due to the center tap 25, one leg 28 of the secondary 26 may be viewed as containing the voltage signal and the other leg 29 may be viewed as containing its complement.

These two signals are provided as inputs to two switches 56 and 58 respectively. The opening and closing of these switches is controlled by the output of comparitor 48. This output 54 is directly coupled to the control of switch 56. The output is also inverted 60 and coupled to the control of switch 58. Inversion is caused by inverting gate 62.

If the switches and their controls are comprised of a conventional C-MOS, bipolar switch, a preliminary inverting gate (not shown) may be used between comparitor 48 and switch 56 and inverting gate 62 for the purposes of signal conditioning.

A ONE signal out of comparitor 48 may be adapted to close switch 56, gating the voltage signal through a summing junction 37 into the dual slope integrating A/D converter 32. The ZERO signal out of comparitor 48 may be used to close switch 58 to gate the complement signal into the A/D converter 32.

Both switches 56 and 58 may be closed momentarily. Resistors (not shown) may be employed on both lines 28 and 30 to limit current in this case.

The dual slope integrating A/D converter 32 is a commercially available chip such as the TL501A manufactured by Texas Instruments, Inc., of Dallas, Texas. It possesses an auto zero function, the capability to integrate a signal input on line 38, as well as the ability to integrate toward a reference voltage internal to it. During idle periods, the microprocessor, via control inputs generally representated by input 36, commands the chip 32 to zero itself. At the beginning of an integrating period, the microprocessor commands the chip 32 to begin integrating the input on line 38 which is the output of the multiplier circuit 30. The voltages present on the output of the multiplier 30 will alternate between plus and minus voltages as first one then the other of switches 56 and 58 is closed; but the average will be either a plus voltage or a minus voltage depending on the arrangement of the multiplier's internal circuitry. This average plus or minus voltage is representative of power. Integration causes a corresponding plus or minus integrated voltage to appear on capacitor 64 connnected to the chip 32.

At the end of the integrating period, the microprocessor commands the chip 32 to begin integration toward a reference voltage. The reference voltage is of opposite polarity from the voltage accumulated on the integrating capacitor 64. The time it takes for the integrator to integrate to zero volts is proportional to the charge on the integrating capacitor 64, which is again proportional to the output of the multiplier circuit, which is V times I, or power.

The microprocessor 34 contains an internal timer and times how long it takes from the moment it commands integration toward the reference to the moment the chip 32 signals zero crossing via line 40. The resulting time is proportional to power. The microprocessor 34 may, through an internal algorithm, convert this time to a digital representation of power.

The TL501A chip contains within it circuitry which automatically compensates for input offset errors in its internal amplifiers. This feature, in combination with capacitor 50, tends to minimize input offset errors from both the four-quadrant multiplier 30 and the dual-slope, integrating A/D converter 32. Other such inaccuracies in the circuits may be substantially compensated for by calibration.

Calibration is achieved by potentiometer 66. This potentiometer includes, in part, a manually adjustable variable resistor 67. Adjustment of potentiometer 66 adjusts the reference voltage towards which the A/D converter reverse integrates.

In the factory, a calibrated power meter is connected to the high voltage side 14 of the high voltage transformer 12 and the microprocessor is caused to display through the microwave oven's display means (not shown) the power the power sensing circuit 2 is reading. An assembler then adjusts the potentiometer 66, which in turn adjusts the internal circuitry of the chip 32, until the power readings reported by the microprocessor and the power readings reported by the power meter are the same.

Field calibration is achieved by knowing the efficiency ratio of every transformer. Should a transformer in the field have to be replaced, the new transformer's efficiency can be compared to the old transformer's efficiency and a set number of turns on the manually adjustable potentiometer to compensate for the variations can be entered by the field repairman.

As the current wave through the high voltage transformer's primary 22 contains significant power into the fifth harmonic, the frequency of the triangle wave generator must be such as to give a reasonably accurate picture of this harmonic. In the preferred embodiment, the frequency of the triangle wave is 2400 Hz which is an eight to one ratio over the fifth harmonic. Accuracy in terms of the number of samples of the higher order harmonics may be increased from this point at the cost of component accuracy in many other areas. At 2400 Hz, peak sharpness and slope linearity of the triangle wave is achieved at a reduced cost of components.

It should be noted at this point that power sensing on the low voltage side of the high voltage transformer 12 is not practical should the high voltage transformer have a significant deterioration in efficiency over the lifetime of the microwave oven. Care should be taken in this regard in the selection of an appropriate high voltage transformer.

Additionally, as the object of sensing power into the magnetron 16 is to indirectly determine the power output of the magnetron, the magnetron power conversion efficiency should not change significantly over its expected lifetime. Most commercially available magnetrons now possess this characteristic.

This completes a description of the preferred embodiment of the present invention. It may be appreciated by those skilled in the art that the above circuits are only functionally represented and therefore many variations may be introduced without departing from the scope and spirit of the present invention.

Wherefore, in view of the above specification we claim:

Claims:

1. In a microwave oven having a magnetron, a power supply circuit including a high voltage transformer, and means for controlling cooking time based upon the power consumed by said magnetron, the improvement comprising:

(a) means for developing a signal proportional to voltage across the primary of said high voltage transformer;

(b) means for developing a signal proportional to current through said primary;

(c) means for multiplying said signals together to form a signal proportional to power through said primary;

(d) means for time averaging said power signal for a predetermined period of time;

(e) means for converting the time averaged signal into a digital representation of power; and

(f) means for calibrating said converting means such that said digital representation corresponds to the power consumed by said magnetron.

2. Apparatus according to claim 1 wherein said multiplying means comprises a four-quadrant multiplier including:

a triangle wave generator;

a capacitor coupled on one side with said generator;

a comparitor having one input coupled to the other side of said capacitor and having one of said signals coupled to the other input;

means for branching and inverting the other of said signals to form its complement;

said other signal coupled through a first switch to a summing junction;

said other signal's complement coupled through a second switch to said summing junction;

the output of said comparitor controllably interconnected with said first switch; and

said output controllably interconnected through inverting means to said second switch.

3. Apparatus according to claim 2 wherein said other signal generating means comprises a transformer, and wherein said complement forming means comprises:

a secondary to said transforming having a center tap to ground wherein one leg carries said signal and the other leg carries said signal complemented.

4. Apparatus according to claim 1 wherein said means for time averaging and said means for converting comprise a dual-slope, integrating, analog to digital converter.

5. Apparatus according to claim 2 wherein the frequency of said triangle wave generator is eight times the frequency of the fifth harmonic of the current through said primary.

6. Apparatus according to claim 4 wherein said means for converting further comprises a microprocessor having means to time the reverse integration of said analog to digital converter.

7.      The apparatus of claim 4 wherein said means for calibrating comprises a manually adjustable potentiometer for adjusting the reference voltage which said analog to digital converter reverse integrates.

8.      Method of sensing power input to a microwave oven magnetron having a high voltage power supply circuit including a magnetron comprising the steps of:

(a)   developing a signal proportional to the voltage across the primary of said high voltage transformer;

(b)   developing a signal proportional to  the current through said primary;

(c)   four-quadrant multiply said signals together;

(d)   integrating the multiplied signals for a predetermined period of time;

(e)   converting the integrated, multiplied signals into a digital value proportional to power;

(f)   factory calibrating said conversion such that said digital value is representative of power input to said magnetron.

9.      The method of claim 8 wherein the step of four-quadrant multiplying includes:

(a)   pulse-width modulating one of said signals;

(b)   multiplexing the other signal and its complement into a summing junction by means of switches controlled by said modulated signal, a ONE signal closing one switch and a ZERO signal closing the other switch.

10.     The method of claim 2 wherein said predetermined period of time is sufficient to encompass the major impedance variations on the magnetron's output.

11.     The method of claim 8 wherein said factory calibrating comprises connecting a power meter to the high voltage side of said transformer;

comparing said digital value to the power measured by said power meter; and

adjusting the converting of the integrated, multiplied signals until said digital value is representative of the power measured by said power meter.

12.     In a four-quadrant pulse-width modulated multiplier of the type having a first signal compared to a reference triangle wave via a comparitor, the output of the comparitor controlling gating switches for a second signal and its complement, the improvement comprising:

a capacitor connected in series between the source of the triangle wave and said comparitor.

13.     Apparatus for sensing power input to a microwave oven magnetron from the low voltage side of the magnetron's high voltage transformer, comprising:

means for developing a signal proportional to voltage across the primary of said high voltage transformer;

means for developing a signal proportional to current through said primary;

means for multiplying said signals together;

means for integrating the multiplied signals  for a predetermined period of time;

means for converting the integrated, multiplied signals into a digital value proportional to power.

**Fig. 1**

**Fig. 2**